# EUROPEAN PATENT SPECIFICATION

(11) **EP 0 388 179 B1**
(45) Date of publication and mention of the grant of the patent: **03.07.1996**
(21) Application number: 90302719.1
(22) Date of filing: 14.03.1990
(51) Int. Cl.: H01L 23/532, H01L 21/768

(54) **Semiconductor device having multilayer wiring and the method of making it**
Halbleitervorrichtung mit Mehrlagenverdrahtung und Verfahren zu ihrer Herstellung
Dispositif semi-conducteur ayant un câblage à plusieurs couches et procédé pour faire celui-ci

(30) Priority: 14.03.1989 JP 61556/89
(43) Date of publication of application: 19.09.1990
(60) Divisional application: 93202460.7
(73) Proprietor: KABUSHIKI KAISHA TOSHIBA, Kawasaki-shi, Kanagawa-ken 210 (JP)
(72) Inventor: Noguchi, Tatsuo, c/o Intellectual Property Div., Tokyo (JP); Yoshida, Masayuki, c/o Intellectual Property Div., Tokyo (JP); Hatanaka, Kazuhisa, c/o Intellectual Property Div., Tokyo (JP); Tanaka, Shigeru, c/o Intellectual Property Div., Tokyo (JP)
(74) Representative: Freed, Arthur Woolf

(56) References cited:
- EP-A- 0 100 999
- EP-A- 0 133 023
- EP-A- 0 248 266
- EP-A- 0 317 161

## Description

This invention generally relates to semiconductor devices and more specifically to improvements in wiring for LSIs.

In general, the wiring used in LSIs can be devided into the main power source wiring for supplying power to the elements, power source branch wiring that connects the power source main wiring with the individual elements, and signal wiring that transmits signals between the elements. This wiring is normally made of a material whose main constituent is aluminium (Al), but some very short signal wires may be of monocrystalline silicon, a refractory metal or a refractory metal silicide etc.

In memories, part of the diffusion layer may be utilized for wiring; multiple layers of polycrystalline silicon (partly, a refractory metal silicide) are sometimes employed as wiring. Alternatively, wiring using new materials such as copper (Cu) may be employed.

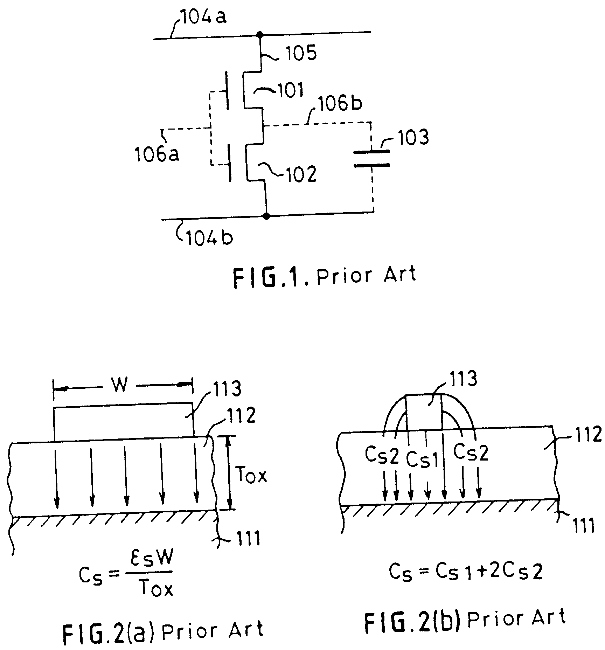

Furthermore, gate arrays or CPUs etc, or the logic LSIs of recent years are formed using metallic wiring layers consisting of at least two layers, in order to increase the degree of circuit integration. Fig. 1 shows diagrammatically, using the case of a CMOS inverter circuit, the difference between signal wiring, power source main wiring, and power source branch wiring. In Fig. 1, reference numerals 104a and 104b indicate power source main wiring, reference numeral 105 indicates power source branch wiring and reference numerals 106a and 106b indicate signal wiring. Power source main wiring 104a and 104b and power source branch wiring 105 normally have d.c. current flowing in them on application of a d.c. voltage, or have a d.c. pulse current flowing in them which is turned on or off with FET elements 101, 102. In general, these currents flow in one direction. In contrast, signal wires 106a and 106b, particularly in a CMOS LSI, have bidirectional pulse current flowing in them produced by charging and discharging of capacitive load. The metal used in multi-layer wirings is exclusively aluminium or an alloy thereof. Even in a layout in which multi-layer wiring is used, different wiring materials were not been used for particular power source main wiring 104a and 104b and signal wiring 106 and 106b.

When current flows in Al wiring of a conventional semiconductor device, so-called electromigration occurs, wherein Al atoms migrate under the influence of the electric current flowing. This may even result in disconnection of the circuit. Since this electromigration increases with current density, the problem becomes much more marked when the wiring is made finer. To prevent this, it is usual to make power source main wiring, in which large current flows, of greater wiring width. However in devices in which the size of the wiring is the limiting factor to reducing area, as in the case of logic LSIs, there has been the problem that the size of such devices could not be reduced. This problem has appeared with advances in miniaturization in signal wiring and power source branch wiring, since, from the point of view of obtaining a high degree of circuit integration, they should be thin, but, from the point of view of current density, they need to be wide.

Also, there has been a problem regarding the capacitance Cs per unit of wiring length. As shown in Fig. 2a, when the wiring is of some minimum width, the capacitance is determined by the wiring width W and the film thickness between wiring 113 and substrate 111. However, when miniaturization of the elements requires reduced wiring width W, as shown in Fig. 2b, the capacitance Cs₂ between the side faces of wiring 113 and the substrate 111 becomes important. In order to reduce the capacitance and thereby increase the speed of LSIs, it is desirable to increase the thickness of the film between the wiring and substrate, but in general this is difficult since such a method runs counter to element miniaturization. For this reason, the aim is normally to lower capacitance by making the width of the wiring and the film thickness small. Thus, in order to obtain high degrees of circuit integration, the wiring of the signal wiring is made of the minimum workable dimensions.
However, this has led to the problem that, when Al was used as the material of the wiring, such minimum workable dimensions could not be used for the wiring dimensions, because of electromigration. Consideration was therefore given to increasing resistance to electromigration by using materials other than Al for the wiring. However, materials of high resistance to electromigration, such as refractory metals such as tungsten or refractory metal silicides, in general have an electrical resistance several orders of magnitude higher than that of Al. It was therefore difficult to employ these materials for signal wires, where the propagation delay of the signal is critical. Therefore they could only be used for wiring of very short length.

It is known to use materials of differing resistance to electromigration, as described in EP-A-0 133 023 and in earlier European application EP-A-0 317 161 which is relevant under Art. 54(3) EPC.

Accordingly, an object of this invention is to provide a semiconductor device having a multilayer wiring and the method of making it whereby a high degree of integration and high speed can be achieved, as well as high reliability.

This object is achieved according to one aspect of the present invention by providing a new and improved semiconductor device having a multilayer wiring including:
a first wiring element made of a first material for carrying direct current or pulsed direct current to at least one element of said semiconductor device,
a second wiring element for supplying power made of a second material to a plurality of elements of the semiconductor device, and
a third wiring element made of said second material for carrying bidirectional signals to at least one element of the semiconductor device, wherein the resistance to electromigration of the first material is higher than the resistance to electromigration of the second material.

The present application describes a semiconductor device having multilayer wiring including main power source wiring for supplying power to a plurality of elements of the semiconductor device and signal wiring for transmitting bidirectional signals to at least one element, wherein at least one wiring layer of the multilayer wiring is comprised only of the signal wiring.

This application also describes a semiconductor device having multilayer wiring including main power source wiring for supplying power to a plurality of elements of the semiconductor device, and signal wiring for transmitting signals between the elements, wherein at least one wiring layer of the multilayer wiring is comprised only of the main power source wiring, and another wiring layer comprising the signal wiring is located under the at least one wiring.

According to another aspect of the present invention there is provided a semiconductor device including a p-type MOS transistor and an N-type MOS transistor, each with a source, a gate, and a drain and having a multilayer wiring for providing power and control signals to elements of the semiconductor device, the semiconductor device comprising:
a first wiring element made of one of a refractory metal, a refractory metal silicide, and copper, comprising first and second power source branch wires and a first signal wire, wherein
the first power source branch wire connects the first power source main wire to the source of the P-type MOS transistor and transmits one of a direct current and a pulsed direct current;
the second power source branch wire connects the second power source main wire to the source of the N-type MOS transistor and transmits one of a direct current and a pulsed direct current;
the first signal wire connects the drain of the P-type MOS transistor to the drain of the N-type MOS transistor and transmits one of a direct current and a pulsed direct current;
a second wiring element made of aluminum, comprising first and second power source main wires; and
a third wiring element made of aluminum, comprising a second signal wire and a third signal wire, wherein the second signal wire connects the gate of the P-type MOS transistor to the gate of the N-type MOS transistor and transmits bidirectional current, and the third signal wire is connected to the first signal wire and transmits a bidirectional output signal to at least one element of the semiconductor device.

The aforementioned object of the invention is also achieved according to a further aspect of the present invention by providing a new and improved method of fabricating a semiconductor device having a multilayer wiring including the steps of:
forming a first wiring element of a first material for carrying direct current or pulsed direct current to at least one element of the semiconductor device;
forming a second wiring element of a second material for supplying power to a plurality of the elements of the semiconductor device; and
forming a third wiring element of the second material wherein the resistance to electromigration of the first material is higher than the resistance to electromigration of the second material.

This application also describes a method of making a semiconductor device including the steps of, forming a thin wiring layer for bidirectional signal wiring only, forming an insulating on the first wiring layer, and forming another wiring layer thicker than and above the first wiring layer for carrying direct current power signals.

A more complete appreciation of this invention and many of the attendant advantages there of will be readily obtained as the same becomes better understood from the following detailed description given by way of example only and with reference to the accompanying drawings, wherein:
Figure 1 is a circuit diagram of a CMOS inverter;
Figure 2a and 2b are views given in explanation of wiring capacitance;
Figure 3a through 3f show fabrication of wiring layers in accordance with a first embodiment of a semiconductor device according this invention;
Figure 4a and 4b are cross-sectional view of a semiconductor device of the first embodiment shown in Figure 3f;
Figure 5 is an equivalent circuit diagram of the semiconductor device according to this invention;
Figure 6a through 6h show fabrication of wiring layers in accordance with a second embodiment of a semiconductor device according to this invention;
Figure 7a and 7b are cross-sectional view of a semiconductor device of the second embodiment shown in Figure 6h;
Figure 8 is an equivalent circuit diagram of the semiconductor device of the second embodiment shown in Figure 6;
Figure 9 is a graph showing the test results of a comparison of resistance to electromigration in which a.c. and d.c. currents respectively were allowed to flow in the wiring;

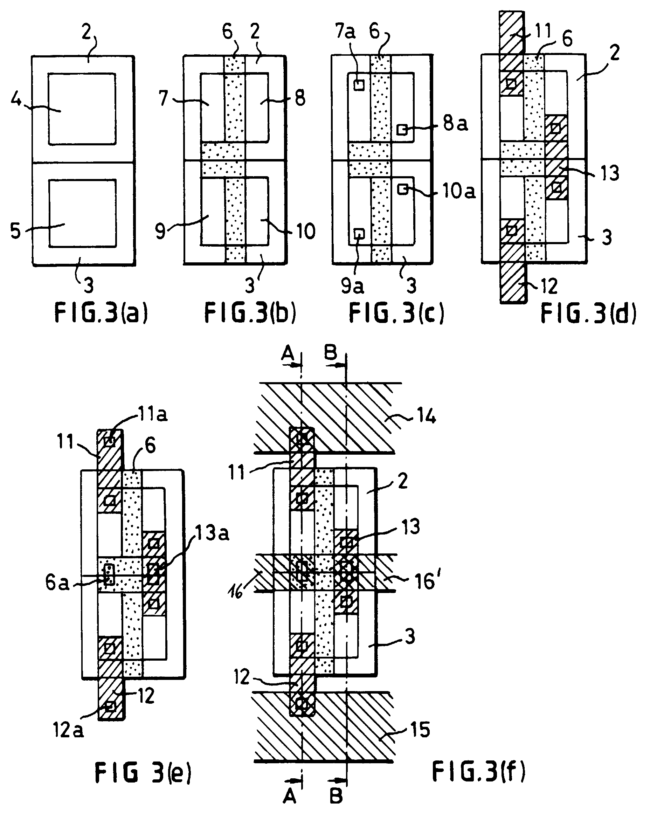

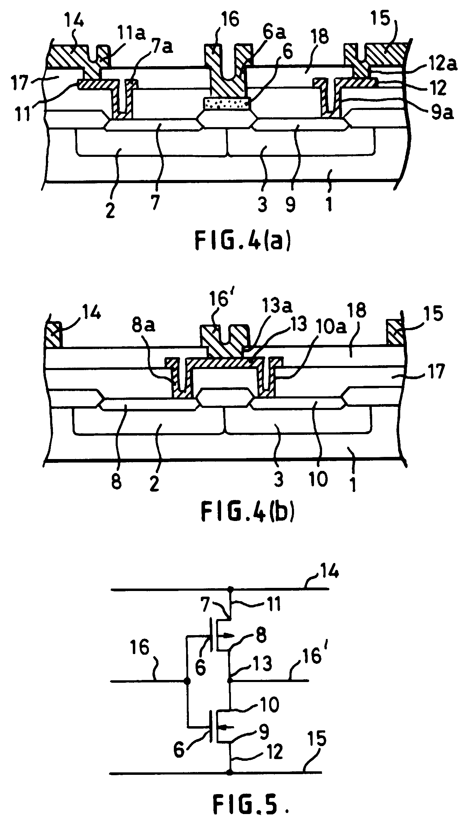

A first embodiment of a semiconductor device according to this invention is described with reference to the formation of a CMOS inverter shown in Fig. 3 and Fig. 4.

Respective element regions 4 and 5 are formed in N well region 2 and P well region 3 each formed on a monocrystalline silicon substrate 1 (see Fig. 3a). A thick silicon oxide film is formed separating element regions 4 and 5 by the normally-used selective oxidation method employing a silicon nitride film. Next, gate oxide film of 15 nm for example is formed on element regions 4 and 5 and doping with impurity is effected in order to obtain the required threshold voltage values. A polycrystalline silicon layer is then deposited over the entire surface and the polycrystalline silicon layer is made conductive by introducing phosphorus. After this, gate electrodes 6 are formed by patterning the polycrystalline silicon layer as shown in Fig. 3b. Then, boron is introduced into the portions of the element region on N well 2 where gate electrode 6 is not formed, and arsenic is introduced into the portions in the element region on P well 3 where gate electrode 6 is not formed, to form a P channel transistor with source 7 and drain 8 and N channel transistor source 9 and drain 10 (see Fig. 3b).

Then a first silicon oxide film 17 (see Figs. 4a and 4b) is deposited to a thickness of 1 µm over the entire surface, and is formed with respective connection holes 7a, 9a and 8a, 10a to sources 7,9 and drains 8,10 (see Fig. 3c). Next, a material of high resistance to electromigration, for example tungsten, is deposited in a thickness of 1 µm over the entire surface, and power source branch wires 11, 12 and signal wires 13 are formed as shown in Fig. 3d by patterning. Next, a silicon oxide film 18 (see Figs. 4a and 4b) is deposited in a thickness of 1 µm over the entire surface, and connection holes 11a, 12a and 13a with power source branch wires 11 and 12 and signal wire 13, as well as connection hole 6a to the gate electrode are formed (see Fig. 3e). Next, power source main wires 14 and 15 and signal wire 16, 16' are formed (see Fig. 3f) by patterning after sputtering a first 1 µm thick layer of Al over the entire surface.

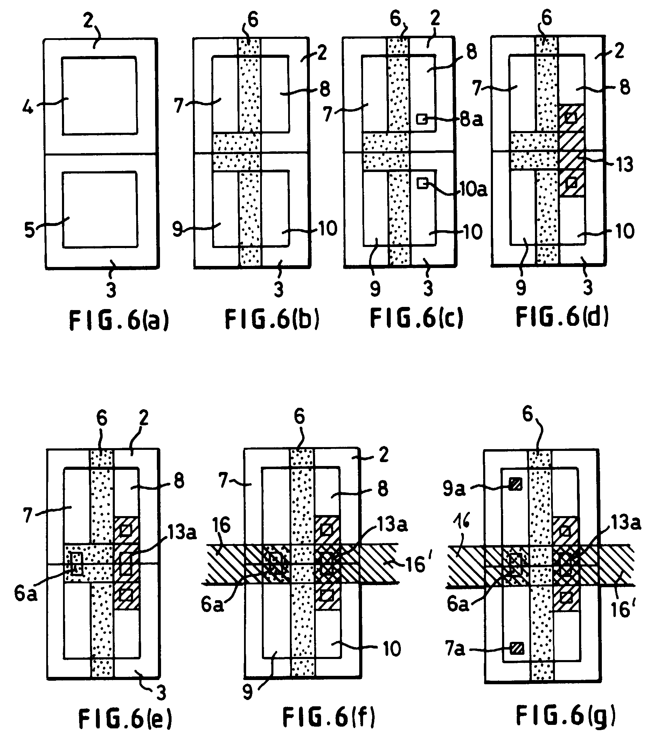

Fig. 4a shows the cross-section along the line A-A of Fig. 3f, and Fig. 4b shows the cross-section along the line B-B of Fig. 3f. Fig. 5 shows the equivalent circuit of the CMOS inverter shown in Fig. 3f. Reference numerals 11, 12 and 13 are power source branch wires 11 and 12 and signal wire 13 respectively, shown by thick lines in Fig. 5.

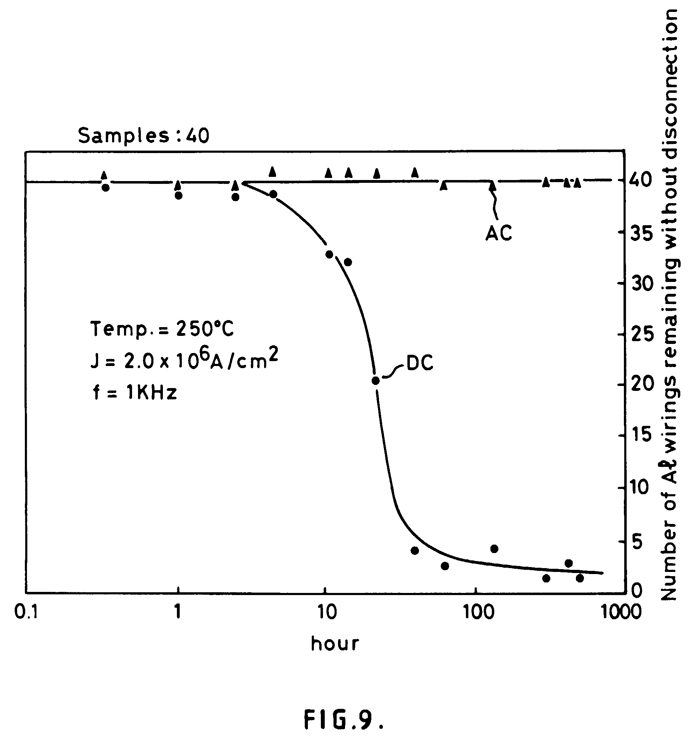

The signal wire is the wiring that transmits the signals between the elements (for example, the drain of one element and the gate electrode of another element). There are a large number of these wires having connections with the miniaturized transistors, and they must be of the same size as the transistors. Although bidirectional current flows in the CMOS signal wire, according to experimental results (see Fig. 9), the resistance to electromigration of the wiring in which bidirectional current flows is, in terms of lifetime, about two orders of magnitude longer than that of wiring in which one directional current flows, i.e., in terms of allowed current, about one order of magnitude greater. That is, wiring in which bidirectional current flows can be made one order of magnitude narrower than wiring in which an equivalent d.c. current flows and experience a similar lifetime. The experimental data in Fig. 9 shows results for the case in which the ambient temperature is 250° C, the current density J is 2.0 x 10⁶ A/cm², and the frequency f of the a.c. is 1 kHz.

As described above, with this embodiment, a high degree of circuit integration and high speed circuit operation can be obtained by using Al, which has low resistance and can easily be worked for small sized wiring such as wire 16, 16' in which bidirectional current flows. Also, miniaturization can be achieved and high reliability obtained by using tungsten, which is not susceptible to electromigration, for the power source branch wires 11, 12 and signal wire 13, in which one directional current flows. Power source branch wires 11, 12 and signal wire 13 can be made short, so the voltage drop due to the resistance of the tungsten (about one order of magnitude higher than that of Al) can be practically neglected, and does not interfere with obtaining increased speed of operation.

There is a considerable problem regarding electromigration in the power source main wire since a large one directional current flows in this wire due to the high degree of circuit integration of present day LSI. However, since the power source main wiring need not directly connect to the elements, this wire can be made a separate layer from the other wiring since there is no need for miniaturization of this wire. In this embodiment, Al is used, but there is no particular restriction on the kind of material which can be used.

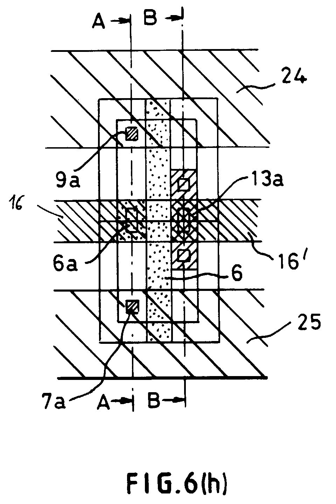

A second embodiment of a semiconductor device according to this invention will now be described with reference to Fig. 6 through Fig. 8.

Respective element regions 4 and 5 are formed (Fig. 6a) in N well region 2 and P well region 3 formed on single-crystal silicon substrate 1. This can be achieved by the normally employed selective oxidation method using a silicon nitride film, a thick film of silicon oxide being formed in regions other than the element regions 4 and 5. Next, on element regions 4 and 5, a gate oxide film of for example 15 nm thickness is formed, and impurities are introduced to obtain the required threshold voltages. A polycrystalline silicon film is then deposited over the entire surface, and this polycrystalline silicon layer is rendered conductive by doping with phosphorus. As shown in Fig. 6b, gate electrodes 6 are then formed by patterning the polycrystalline silicon film. Next, by doping with boron the parts of the element region on N well 2 that are not formed with gate electrode 6, and doping with arsenic the parts of the element region on P well 3 that are not formed with gate electorde 6, source 7 and drain 8 of the P channel transistors and source 9 and drain 10 of the N channel transistors are formed (see Fig. 6b).

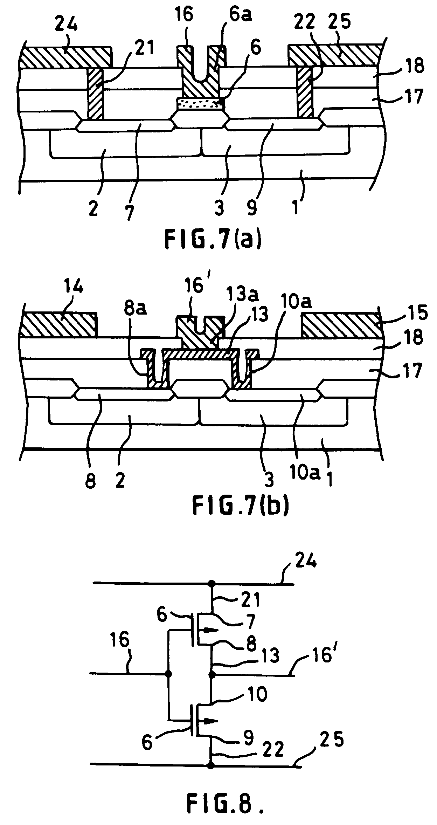

Then a silicon oxide film 17 (see Fig. 7a and 7b) is deposited in a thickness of 1 µm over the entire surface, and connection holes 8a and 10a with the drains 8 and 10 are formed (see Fig. 6c). Next, a material of high resistance to electromigration, such as for example, tungsten, is deposited in a thickness of 1 µm over the entire surface, and signal wires 13 are formed by patterning as shown in Fig. 6d. Next, a silicon oxide film 18 (see Fig. 7a and 7b) is deposited in a thickness of 1 µm over the entire surface, and is formed with connection holes 13a and 6a with the gate electrodes (see Fig. 6e). Then, Al is sputtered to a thickness of 1 µm over the entire surface, and signal wires 16, 16' are formed by patterning (see Fig. 6f).

Next, a silicon oxide film (not shown) is deposited in a thickness of about 1 µm over the entire surface, and is formed with connection holes 7a and 9a with sources 7 and 9. Then perpendicular wiring 21 and 22 is formed of tungsten by depositing tungsten so that only the openings are filled with tungsten (see Fig. 6g and Fig. 7a and 7b). Next, power source wires 24 and 25 are formed by patterning (see Fig. 6h) after depositing an Al film of 1 µm thickness over the entire surface.

Fig. 7a shows a cross-section along with the line A-A, and Fig. 7b shows a cross-section along the line B-B of Fig. 6h. Fig. 8 shows an equivalent circuit of the semiconductor device shown in Fig. 6h. Reference numerals 21, 22 and 13 are respectively power source branch wires 21, 22 and signal wire 13, shown by thick lines.

As described above, tungsten, which is of high resistance to electromigration, is used for power source branch wires 21 and 22, and for signal wire 13, in which one directional current flows, while Al, which can easily be worked for small sized wiring, and is of low resistance, is used for signal wire 16, 16', in which bidirectional current flows. In this way, the semiconductor device of this embodiment can provide the same benefits as that of the first embodiment.

It should be noted that, while in the first and second embodiments tungsten was used as the material of high resistance to electromigration, the same benefits could be obtained by the use of other refractory metals, refractory metal silicides or copper.

Also, although Al was used for power source main wires 14, 15, 24, and 25, other conductive materials could be used.

In the case of the embodiments of Fig. 3 and Fig. 4, a CMOS inverter was shown as an example. However, similar fabrication steps could also be applied to other circuits such other logic circuit elements like NAND or NOR gates.

As described above, with this invention, a semiconductor device of a higher degree of circuit integrataion, improved speed and high reliability can be obtained.

## Claims

1. A semiconductor device having multilayer wiring for providing power and control signals to elements of said device comprising:
a first wiring element (11, 12, 13) made of a first material and designed for carrying direct current or pulsed direct current to at least one element of said semiconductor device;
a second wiring element (14, 15) made of a second material and designed for supplying power to a plurality of elements of the semiconductor device; and
a third wiring element (16, 16') made of said second material and designed for carrying bidirectional signals to at least one element of said semiconductor device, wherein the resistance to electromigration of the first material is higher than the resistance to electromigration of the second material.

2. A semiconductor device according to claim 1, wherein the resistivity of the second material is lower than the resistivity of the first material.

3. A semiconductor device according to claim 1 or 2, wherein the second material comprises aluminium.

4. A semiconductor device according to claim 1, 2 or 3, wherein the first material has a higher melting point than the second material.

5. A semiconductor device according to claim 1, 2 or 3, wherein the first material comprises a refractory metal silicide.

6. A semiconductor device including a p-type MOS transistor and an N-type MOS transistor, each with a source (7, 9), a gate (6), and a drain (8, 10) and having a multilayer wiring for providing power and control signals to elements of the semiconductor device, the semiconductor device comprising:
a first wiring element (11, 12, 13) made of one of a refractory metal, a refractory metal silicide, and copper, comprising first and second power source branch wires (11, 12) and a first signal wire (13), wherein
the first power source branch wire (11) connects the first power source main wire (14) to the source (7) of the P-type MOS transistor and transmits one of a direct current and a pulsed direct current;
the second power source branch wire (12) connects the second power source main wire (15) to the source (9) of the N-type MOS transistor and transmits one of a direct current and a pulsed direct current;
the first signal wire (13) connects the drain (8) of the P-type MOS transistor to the drain (10) of the N-type MOS transistor and transmits one of a direct current and a pulsed direct current;
a second wiring element (14, 15) made of aluminum, comprising first and second power source main wires (14, 15); and
a third wiring element (16, 16') made of aluminum, comprising a second signal wire (16) and a third signal wire (16'), wherein the second signal wire (16) connects the gate (6) of the P-type MOS transistor to the gate (6) of the N-type MOS transistor and transmits bidirectional current, and the third signal wire (16') is connected to the first signal wire (13) and transmits a bidirectional output signal to at least one element of the semiconductor device.

7. A semiconductor device according to claim 6, wherein the first and second power source branch wires (11, 12) are transverse to the first and second power source main wires (14, 15) respectively, and the second and third signal wires (16) are parallel and lie between the first and second power source main wires (14, 15).

8. A method of fabricating a semiconductor device having multilayer wiring for providing power and control signals to elements of said device, comprising the steps of:
forming a first wiring element (11, 12, 13) of a first material, said first wiring element being provided for carrying direct current or pulsed direct current to at least one element of said semiconductor device;
forming a second wiring element (14, 15) of a second material, said second wiring element being provided for supplying power to a plurality of the elements of the semiconductor device; and
forming a third wiring element (16,16') of said second material said third wiring element being provided for carrying bidirectional signals to at least one element of said semiconductor device, characterized in that the resistance to electromigration of the first material is higher than the resistance to electromigration of the second material.

## Patentansprüche

1. Halbleitervorrichtung mit Mehrlagenverdrahtung zum Liefern von Leistung und von Steuersignalen an Elemente der Vorrichtung mit:
einem ersten Verdrahtungselement (11, 12, 13), das aus einem ersten Material hergestellt ist und zum Transportieren von Gleichstrom oder pulsierendem Gleichstrom an mindestens ein Element der Halbleitervorrichtung bestimmt ist;
einem zweiten Verdrahtungselement (14, 15), das aus einem zweiten Material hergestellt ist und zum Liefern von Leistung an eine Vielzahl von Elementen der Halbleitervorrichtung bestimmt ist; und
einem dritten Verdrahtungselement (16, 16'), das aus dem zweiten Material hergestellt ist und zum Transportieren von bidirektionalen Signalen an mindestens ein Element der Halbleitervorrichtung bestimmt ist, wobei der Widerstand des ersten Materials gegen Elektromigration höher ist als der Widerstand des zweiten Materials gegen Elektromigration.

2. Halbleitervorrichtung nach Anspruch 1, wobei der spezifische Widerstand des zweiten Materials niedriger ist als der spezifische Widerstand des ersten Materials.

3. Halbleitervorrichtung nach Anspruch 1 oder 2, wobei das zweite Material Aluminium umfaßt.

4. Halbleitervorrichtung nach Anspruch 1, 2 oder 3, wobei das erste Material einen höheren Schmelzpunkt hat als das zweite Material.

5. Halbleitervorrichtung nach Anspruch 1, 2 oder 3, wobei das erste Material ein hochschmelzendes Metallsilicid umfaßt.

6. Halbleitervorrichtung mit einem p-MOS-Transistor und einem n-MOS-Transistor, jeweils mit einer Source (7, 9), einem Gate (6) und einem Drain (8, 10) und mit einer Mehrlagenverdrahtung zum Liefern von Leistung und von Steuersignalen an Elemente der Halbleitervorrichtung, wobei die Halbleitervorrichtung aufweist:
ein erstes Verdrahtungselement (11, 12, 13), das aus einem, nämlich aus einem hochschmelzenden Metall, einem hochschmelzenden Metallsilicid oder Kupfer hergestellt ist, mit einem ersten und einem zweiten Leistungsquellenabzweigdraht (11, 12) und einem ersten Signaldraht (13), wobei
der erste Leistungsquellenabzweigdraht (11) den ersten Leistungsquellenhauptdraht (14) mit der Source (7) des p-MOS-Transistors verbindet und einen, nämlich einen Gleichstrom oder einen pulsierenden Gleichstrom überträgt;
der zweite Leistungsquellenabzweigdraht (12) den zweiten Leistungsquellenhauptdraht (15) mit der Source (9) des n-MOS-Transistors verbindet und einen, nämlich einen Gleichstrom oder einen pulsierenden Gleichstrom überträgt;
der erste Signaldraht (13) den Drain (8) des p-MOS-Transistors mit dem Drain (10) des n-MOS-Transistors verbindet und einen, nämlich einen Gleichstrom oder einen pulsierenden Geichstrom überträgt;
ein zweites Verdrahtungselement (14, 15), das aus Aluminium hergestellt ist, mit einem ersten und einem zweiten Leistungsquellenhauptdraht (14, 15); und
ein drittes Verdrahtungselement (16, 16'), das aus Aluminium hergestellt ist, mit einem zweiten Signaldraht (16) und einen dritten Signaldraht (16'), wobei der zweite Signaldraht (16) das Gate (6) des p-MOS-Transistors mit dem Gate (6) des n-MOS-Transistors verbindet und bidirektionalen Strom überträgt und der dritte Signaldraht (16') mit dem ersten Signaldraht (13) verbunden ist und ein bidirektionales Ausgangssignal an mindestens ein Element der Halbleitervorrichtung überträgt.

7. Halbleitervorrichtung nach Anspruch 6, wobei der erste und der zweite Leistungsquellenabzweigdraht (11, 12) quer zum ersten bzw. zum zweiten Leistungsquellenhauptdraht (14, 15) angeordnet sind und der zweite und der dritte Signaldraht (16) parallel angeordnet sind und zwischen dem ersten und dem zweiten Leistungsquellenhauptdraht (14, 15) liegen.

8. Verfahren zur Herstellung einer Halbleitervorrichtung mit Mehrlagenverdrahtung zum Liefern von Leistung und von Steuersignalen an Elemente der Vorrichtung, mit den folgenden Schritten:
Ausbilden eines ersten Verdrahtungselements (11, 12, 13) aus einem ersten Material, wobei das erste Verdrahtungselement zum Transportieren von Gleichstrom oder pulsierendem Gleichstrom an mindestens ein Element der Halbleitervorrichtung vorgesehen ist;
Ausbilden eines zweiten Verdrahtungselements (14, 15) aus einem zweiten Material, wobei das zweite Verdrahtungselement zum Liefern von Leistung an eine Vielzahl von Elementen der Halbleitervorrichtung vorgesehen ist; und
Ausbilden eines dritten Verdrahtungselements (16, 16') aus dem zweiten Material, wobei das dritte Verdrahtungselement zum Transportieren von bidirektionalen Signalen an mindestens ein Element der Halbleitervorrichtung vorgesehen ist, dadurch gekennzeichnet, daß der Widerstand des ersten Materials gegen Elektromigration höher ist als der Widerstand des zweiten Materials gegen Elektromigration.

## Revendications

1. Un dispositif à semiconducteurs ayant une interconnexion multicouche pour fournir de l'énergie et des signaux de commande à des éléments de ce dispositif, comprenant :
un premier élément d'interconnexion (11, 12, 13) constitué par un premier matériau et conçu pour acheminer un courant continu ou un courant continu pulsé vers au moins un élément du dispositif à semiconducteurs,
un second élément d'interconnexion (14, 15) constitué par un second matériau et conçu pour fournir de l'énergie à un ensemble d'éléments du dispositif à semiconducteurs, et
un troisième élément d'interconnexion (16, 16'), constitué par le second matériau et conçu pour acheminer des signaux bidirectionnels vers au moins un élément du dispositif à semiconducteurs, dans lequel la résistance à l'électromigration du premier matériau est supérieure à la résistance à l'électromigration du second matériau.

2. Un dispositif à semiconducteurs selon la revendication 1, dans lequel la résistivité du second matériau est inférieure à la résistivité du premier matériau.

3. Un dispositif à semiconducteurs selon la revendication 1 ou 2, dans lequel le second matériau consiste en aluminium.

4. Un dispositif à semiconducteurs selon la revendication 1, 2 ou 3, dans lequel le premier matériau a un point de fusion supérieur à celui du second matériau.

5. Un dispositif à semiconducteurs selon la revendication 1, 2 ou 3, dans lequel le premier matériau consiste en un siliciure de métal réfractaire.

6. Un dispositif à semiconducteurs comprenant un transistor MOS de type P et un transistor MOS de type N, ayant chacun une source (7, 9), une grille (6) et un drain (8, 10), et ayant une interconnexion multicouche pour fournir de l'énergie et des signaux de commande à des éléments du dispositif à semiconducteurs, ce dispositif à semiconducteurs comprenant :
un premier élément d'interconnexion (11, 12, 13) constitué par un corps parmi un métal réfractaire, un siliciure de métal réfractaire et le cuivre, comprenant des première et seconde connexions de dérivation de source d'alimentation (11, 12) et une première connexion de signal (13), dans lequel
la première connexion de dérivation de source d'alimentation (11) connecte la première connexion principale de source d'alimentation (14) à la source (7) du transistor MOS de type P et transmet un courant parmi un courant continu et un courant continu pulsé;
la seconde connexion de dérivation de source d'alimentation (12) connecte la seconde connexion principale de source d'alimentation (15) à la source (9) du transistor MOS de type N et transmet un courant parmi un courant continu et un courant continu pulsé;
la première connexion de signal (13) connecte le drain (8) du transistor MOS de type P au drain (10) du transistor MOS de type N et transmet un courant parmi un courant continu et un courant continu pulsé;
un second élément d'interconnexion (14. 15) consistant en aluminium, qui comprend des première et seconde connexions principales de source d'alimentation (14, 15); et
un troisième élément d'interconnexion (16, 16') consistant en aluminium, qui comprend une seconde connexion de signal (16) et une troisième connexion de signal (16'), dans lequel la seconde connexion de signal (16) connecte la grille (6) du transistor MOS de type P à la grille (6) du transistor MOS de type N et transmet un courant bidirectionnel, et la troisième connexion de signal (16') est connectée à la première connexion de signal (13) et elle transmet un signal de sortie bidirectionnel à au moins un élément du dispositif à semiconducteurs.

7. Un dispositif à semiconducteurs selon la revendication 6, dans lequel les première et seconde connexions de dérivation de source d'alimentation (11, 12) sont respectivement orientées transversalement par rapport aux première et seconde connexions principales de source d'alimentation (14, 15), et les seconde et troisième connexions de signal (16) sont parallèles et elles s'étendent entre les première et seconde connexions principales de source d'alimentation (14, 15).

8. Un procédé de fabrication d'un dispositif à semiconducteurs ayant une interconnexion multicouche, pour fournir de l'énergie et des signaux de commande à des éléments du dispositif, comprenant les étapes suivantes :
on forme un premier élément d'interconnexion (11, 12, 13) en un premier matériau, ce premier élément d'interconnexion étant destiné à acheminer un courant continu ou un courant continu pulsé vers au moins un élément du dispositif à semiconducteurs;
on forme un second élément d'interconnexion (14, 15) en un second matériau, ce second élément d'interconnexion étant destiné à fournir de l'énergie à un ensemble des éléments du dispositif à semiconducteurs; et
on forme un troisième élément d'interconnexion (16, 16') constitué par le second matériau, ce troisième élément d'interconnexion étant destiné à acheminer des signaux bidirectionnels vers au moins un élément du dispositif à semiconducteurs, caractérisé en ce que la résistance à l'électromigration du premier matériau est supérieure à la résistance à l'électromigration du second matériau.
